## Europäisches Patentamt

## European Patent Office

## Office européen des brevets

(19)

(11) Veröffentlichungsnummer: **0 019 869**
**B1**

(12) **EUROPÄISCHE PATENTSCHRIFT**

(45) Veröffentlichungstag der Patentschrift:
**09.02.83**

(51) Int. Cl.³: **G 01 R 31/06**, G 01 R 31/00,
**H 02 K 15/00**

(21) Anmeldenummer: **80102872.1**

(22) Anmeldetag: **23.05.80**

(54) **Anordnung zur messtechnischen Erfassung und Überwachung von elektrischen Läuferunsymmetrien in Induktionsmaschinen mit Käfigläufern.**

(30) Priorität: **29.05.79 DE 2921724**

(43) Veröffentlichungstag der Anmeldung:
**10.12.80 Patentblatt 80/25**

(45) Bekanntmachung des Hinweises auf die Patenterteilung:
**09.02.83 Patentblatt 83/6**

(84) Benannte Vertragsstaaten:
**AT BE CH FR GB IT LI NL SE**

(56) Entgegenhaltungen:
**DD-A-133 737**
**US-A-2 640 100**
**US-A-2 844 794**

(73) Patentinhaber: **Schorch GmbH, Breitestrasse 131,
D-4050 Mönchengladbach 2 (DE)**

(72) Erfinder: **Seinsch, Hans-Otto, Dr.-Ing., Flöthwiesen 1,
D-3000 Hannover 51 (DE)**

(74) Vertreter: **Patentanwältsburo Cohausz & Florack,
Schumannstrasse 97, D-4000 Düsseldorf 1 (DE)**

Anordnung zur meßtechnischen Erfassung und Überwachung von elektrischen Läuferunsymmetrien
in Induktionsmaschinen mit Käfigläufern

Die Erfindung betrifft eine Anordnung zur meßtechnischen Erfassung und Überwachung von elektrischen Unsymmetrien eines in einem Ständer einer Induktionsmaschine rotierenden Läufers, insbesondere von solchen Unsymmetrien, die durch Stab- oder Ringbrüche in Induktionsmaschinen mit Käfigläufern hervorgerufen werden, mit Hilfe einer aus einer oder mehreren Windungen bestehenden, in der dem Luftspalt zugewandten Bohrungsfläche des Ständerblechpaketes angeordneten Meßspule.

Weiterhin betrifft die Erfindung eine Anordnung gemäß dem Oberbegriff des Anspruchs 2.

Elektrische Läuferunsymmetrien können bei Induktionsmaschinen sowohl während des Herstellungsprozesses als auch im späteren Betrieb entstehen. Die erstgenannte Kategorie betrifft vor allem Seigerungen, Lunkerbildungen und Schwindungsrisse bei Läufern, deren Käfig im Gießverfahren aus Aluminium oder einer Aluminiumlegierung hergestellt wird. Geringfügige Läuferunsymmetrien sind jedoch auch bei gestifteten Läufern bedingt durch Material-Inhomogenitäten und die eingesetzten Fertigungstechnologien unvermeidlich.

Im späteren Betrieb werden Unsymmetrien in erster Linie durch Stabbrüche, Risse in den Kurzschlußringen oder durch Bruch bzw. chemische Zersetzung der Lötverbindung zwischen den Kurzschlußstäben und Ringen verursacht. Ausgangspunkt für derartige Erscheinungen können mechanische Kräfte als Folge thermischer Dehnungen, insbesondere bei Hochlaufvorgängen, elektromagnetisch angeregte Schwingungen, chemisch aggressive Gase oder dergleichen sein. Solche Unsymmetrien erfahren im Regelfall eine langsame Vergrößerung und werden oftmals erst im Stadium großer Schädigung bemerkt.

Die Erkennung von Fertigungsfehlern bei gegossenen Käfigen ist seit langem Gegenstand eingehender Untersuchungen, vergl. z. B.:

Armour, A. M.
    A Magneto-Electric-Method for Detecting
Walley, J. W.
    Defects in Cast Aluminium Rotor Windings for Squirrel-Cage Motors
    Metallurgial (Manchester) LIV (1956) Nr. 321, S. 43—46;
Trickey, P. H.
    The Cast Rotor Testing by Test Stator Method Transactions AIEE Bd. 65 (1946), S. 139—141;
Mavridis, D.
    Über das Verhalten eines Drehstromasynchronmotors bei Stab- und Ringbrüchen im Läuferkäfig,
    Diss. TH. Hannover 1962
Packer, L. C.
    Means for Testing Rotors
Cross, R. H.; Monchamp, G. E.
    US-Patentschrift 2 640 100
Wright, F. H.
    Testing Device
Winderl, H. F.
    US-Patentschrift 2 844 794

Die bekannten Verfahren zur Fehlererkennung sind teilweise am ausgebauten Läufer, teilweise erst im montierten Zustand der Maschine anwendbar. Beispielsweise führt man ein U-förmiges mit einer Wicklung versehenes Prüfjoch in tangentialer Richtung um den zu prüfenden Käfigläufer und kann auf diese Weise grobe Gußfehler durch eine Änderung des Widerstandes der jeweils umfaßten Läufermasche feststellen. Mit geringerem Aufwand ist ein anderes bekanntes Verfahren verbunden, bei dem der zu prüfende Läufer langsam in einem magnetischen Gleichfeld gedreht wird. Senkrecht zur Feldachse ist eine Meßspule angebracht und mit einem Galvanometer verbunden. Stabfehler machen sich in Ausschlagunterschieden bemerkbar (Verfahren von Armour und Walley).

Das bekannte, sogenannte Prüfständerverfahren von Trickey zielt darauf ab, mit eingebautem Läufer Veränderungen des wirksamen mittleren Läuferwiderstandes aus der Veränderung der Betriebsdaten verglichen mit denen einer symmetrischen Maschine abzuleiten. Der zu untersuchende Läufer wird dazu in einem eigens angefertigten Prüfständer montiert. Die Maschine kann aber auch in einer bestimmten unsymmetrischen Schaltung (z. B. der sogenannten eh-Y-Schaltung) gemessen werden. Diese Verfahren erfordern einen nicht unerheblichen Rechenaufwand zur Auswertung (vgl. z. B. die Dissertation von Mavridis) und sind im übrigen vom Prinzip her für eine Betriebsüberwachung von Läuferunsymmetrien ungeeignet.

Auch in der US-Patentschrift 2 640 100 wird ein Prüfständer-Verfahren vorgeschlagen, welches für eine Fertigungskontrolle vor der Montage vorgesehen ist. Bei diesem Verfahren wird in einem Prüfständer über eine spezielle gleichstromdurchflossene Erregerwicklung ein Gleichfeld erzeugt. Bei Drehung des Läufers in dem künstlich erzeugten Gleichfeld des Prüfständers soll bei Stab- oder

**0 019 869**

Ringbrüchen in dem Käfigläufer eine andere Induktionswirkung in der Meßspule erfolgen als bei einem intakten Läufer. Zur Auswertung des Signals wird eine Meßspule herangezogen, welche einen einzigen Zahn des Prüfständers umschlingt.

Auch bei der Anordnung gemäß US-A-2 844 794 werden Hilfsspulen benutzt, welche nur einen Zahn des Prüfständers umschlingen und sich teilweise nur über einen Teil der axialen Blechpaketlänge erstrecken. Für das vorgeschlagene Prüfverfahren muß in jedem Fall ein spezieller Prüfständer eingesetzt werden. Der Entwurf der Meßspulen wird in der US-Patentschrift ausdrücklich nicht als Teil der Erfindung bezeichnet. Bei der US-A-2 844 794 geht es um die Produktionsprüfung (nicht um die Prüfung während des Betriebes) bestimmter Mindesteigenschaften, wobei diese Lösung nicht auf eine einzelne spezielle Eigenschaft beschränkt sein soll.

Den Extremfall einer Läuferunsymmetrie stellt eine einachsige Wicklung dar, welche bei einem Schleifringläufer in Sternschaltung durch Unterbrechung eines Läuferstranges erzeugt werden kann. Die hieraus entstehenden Veränderungen des Betriebsverhaltens aus der Wirkung der Luftspalt-Grundfelder (Luftspaltfelder der Maschinenpolpaarzahl p) sind unter dem Begriff Görgens-Phänomen seit Jahrzehnten bekannt. Ein solcher Motor erreicht ohne äußeren Antrieb nur 50% seiner synchronen Drehzahl. Man weiß auch, daß bei weniger ausgeprägten Unsymmetrien als Folge z. B. von Stabbrüchen bei Käfigläufern die inversen Strombelags-Drehwellen des Läufers mit dem synchronen Induktions-Drehfeld ein Pendelmoment von doppelter Schlupffrequenz erzeugen. Je nach Aufstellungsbedingungen machen sich Läuferunsymmetrien darum mitunter akustisch bemerkbar, indem der Lautstärkepegel mit doppelter Schlupffrequenz auf- und abschwillt. Diese Erscheinung, die häufig bereits bei fabrikneuen Maschinen aufgrund geringfügiger unvermeidlicher Unsymmetrien im Prüffeld beobachtet werden kann, ist bestenfalls für eine qualitative Aussage über Unsymmetrien im Läuferkreis brauchbar. Der Effekt kann keinesfalls zur gezielten Überwachung von Unsymmetrien herangezogen werden.

Der Erfindung liegt somit die Aufgabe zugrunde, ein brauchbares Überwachungssystem zur Erfassung von Läuferunsymmetrien unter Verwendung eines Signals, welches in eindeutigem Zusammenhang zur Größe der Läuferunsymmetrie steht, zu schaffen.

Zur Lösung der Aufgabe wird erfindungsgemäß eine Anordnung der eingangs genannten Art vorgeschlagen, die dadurch gekennzeichnet ist, daß die Weite der Meßspule in Umfangsrichtung der Bohrungsfläche so bemessen ist, daß das Maschinenhauptfeld, die Wicklungsoberfelder und Zahnsättigungsfelder in ihr keine Spannung, die durch elektrische Läuferunsymmetrien hervorgerufenen zusätzlichen Luftspaltfelder hingegen eine maximale Spannung induzieren. Alternativ kann die Anordnung auch so getroffen werden, daß mehrere Meßspulen beliebiger Weite in Umfangsrichtung der Bohrungsfläche versetzt angeordnet und so in Reihe geschaltet sind, daß die durch die Läuferunsymmetrien induzierte Summenspannung zu einem Maximum, die vom Maschinenhauptfeld induzierte Summenspannung zu null und die von allen übrigen Luftspaltfeldern induzierte Summenspannung null ist bzw. minimal wird.

Nach dem Grundgedanken der Erfindung wird eine Meßspule bestimmter Weite oder die Reihenschaltung einer Anzahl von Meßspulen so in das Ständerblechpaket eingebracht, daß die resultierende Meßspannung eine eindeutige Funktion der auftretenden Läuferunsymmetrie ist. Dabei ist dafür zu sorgen, daß alle im ungestörten Betrieb einer Induktionsmaschine auftretenden Induktions-Drehfelder, vor allem das Maschinenhauptfeld, in den Meßspulen keine Spannung oder nur Spannungen geringer Größe induzieren, welche sich überdies in ihren Frequenzen von den durch elektrische Läuferunsymmetrien bewirkten Spannungen so deutlich unterscheiden, daß sie über Filter selektiert werden können. Die Höhe der Meßspannung kann somit als Grad der Läuferunsymmetrie dienen und in bekannter Weise zur Betätigung von Warn- bzw. Abschalteinrichtungen herangezogen werden.

Um die erfindungsgemäße Anordnung zu treffen, wird zuvor eine Analyse des Luftspaltfeldes vorgenommen. Nach der sog. Drehfeldtheorie läßt sich das Luftspaltfeld von Induktionsmaschinen stets als unendliche Summe von zeitlich und räumlich sinusförmig verlaufenden Feldern (sog. Kreisdrehfeldern) auffassen. Das Feldspektrum im ungestörten, symmetrischen Betrieb läßt sich in 2 Kategorien einteilen, nämlich die über den konstanten Luftspaltleitwert erregten Feldwellen und die aus räumlichen Leitwertschwankungen resultierenden Felder. Zur erstgenannten Kategorie zählt das Maschinen-Hauptfeld der Polpaarzahl p und der Netz-Kreisfrequenz $\omega_1$, auf welchem die grundlegende Wirkungsweise der Maschine beruht, sowie die Wicklungsoberfelder des Ständers und Läufers (in der Literatur manchmal als Läufer-Restfelder bezeichnet). Die Polpaarzahlen der Oberfelder hängen von der Art der Ständerwicklung und der Stabzahl im Läufer ab. Die Wicklungsoberfelder des Ständers sind netzfrequent, die Läuferrestfelder induzieren in der Ständerwicklung Spannungen der Kreisfrequenz

$$\omega = \omega_1 \left\{ 1 + \frac{g_2 N_2}{p} (1 - s) \right\} .$$

Hierin bedeutet $N_2$ die Läufernutzahl, s den Schlupf und $g_2$ jede positive und negative ganze Zahl. Von den über Leitwertschwankungen erregten Feldern besitzen insbesondere die sog. Nutungsfelder

3

0 019 869

und die Felder aus der Leitwertschwankung der Zahnsättigung Bedeutung.

Wenn der Läufer elektrisch unsymmetrisch ist, z. B. als Folge eines gebrochenen Stabes, so liefert die analytische Berechnung der unsymmetrischen Anordnung zusätzliche Induktionsdrehfelder, welche die Polpaarzahl

$$\lambda = \pm 1; \pm 2; \pm 3; \pm 4; \ldots$$

und die auf den Ständer bezogenen Kreisfrequenzen

$$\omega_\lambda = \omega_1 \left\{ \frac{\lambda}{p} (1 - s) + s \right\}$$

besitzen.

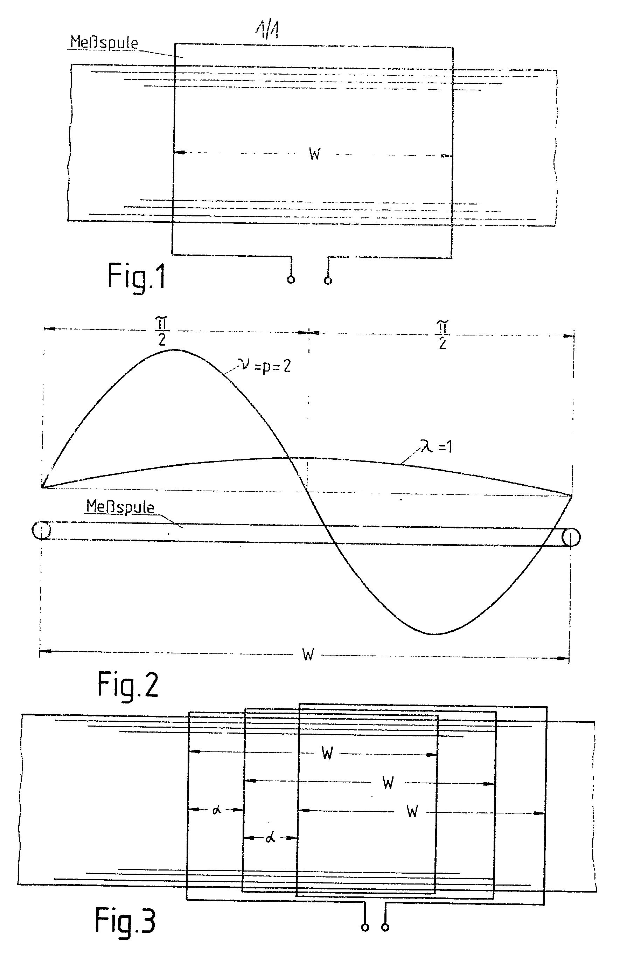

Der erfindungsgemäße Gedanke läßt sich am einfachsten realisieren, wenn eine Weite der Meßspule W (vergl. Figur 1) ausführbar ist, bei der die durch elektrische Läuferunsymmetrien hervorgerufenen zusätzlichen Luftspaltfelder eine maximale Spannung induzieren, wohingegen alle in Zusammenhang mit der Zielsetzung als Störfelder zu bezeichnenden Anteile keine Spannung induzieren. Wegen ihrer Größe müssen natürlich in erster Linie das Maschinen-Hauptfeld, aber auch die Wicklungsoberfelder und die Zahnsättigungsfelder aus der Meßspannung eliminiert werden. Figur 2 verdeutlicht, daß bei einer 4-poligen Maschine die Zielsetzung bezüglich des Hauptfeldes $p = 2$ und des durch eine Unsymmetrie verursachten Feldes $\lambda = 1$ mit Hilfe einer Durchmesserspule $W = 2\tau$ gelöst wird.

Für den allgemeinen Fall muß die Induktionswirkung für alle vorkommenden Felder mit Hilfe des sog. Sehnungs-Wicklungsfaktors

$$\xi_{S\mu} = \sin \frac{\mu}{p} \frac{W}{\tau} \frac{\pi}{2}$$

untersucht werden. Darin ist die Polpaarzahl der betrachteten Feldwelle mit $\mu$, die Spulenweite mit W und die Polteilung des Maschinen-Grundfeldes mit $\tau$ bezeichnet.

Bei Maschinen mit geradzahligen Polpaarzahlen p beträgt beispielsweise die Weite der Meßspule $W = p \cdot \tau$. Die Wicklungsfaktoren aller bezeichneten Störfelder sind dann stets gleich 0, für die auszuwertenden Felder $\lambda = 1; 3; 5; \ldots$ errechnet sich eine maximale Induktionswirkung.

Bei Maschinen mit beliebigen Polpaarzahlen p sind Meßspulen der Weite $W = 2\tau$ einsetzbar. Alle durch Läuferunsymmetrien bewirkten Felder, für welche $\lambda/p$ gebrochen ist, induzieren in der Hilfswicklung Spannungen, das Maschinen-Hauptfeld, die Ständerwicklungsoberfelder, die Ständernutungsfelder und die Felder der Zahnsättigung hingegen nicht. Bei den als Störfeldern anzusprechenden Läuferrestfeldern des Grundstrombelages und den Läufer-Nutzungsfeldern entsteht eine Induktionswirkung nur in den vergleichsweise seltenen Fällen, daß das Verhältnis $N_2/p$ eine gebrochene Zahl ergibt. In diesen Fällen läßt sich die durch die Störfelder in den Meßspulen entstehende Spannung wegen ihrer, nach oben genannter Gleichung, völlig unterschiedlichen Frequenz im Vergleich zu den von den Nutzfeldern induzierten Spannungsanteilen leicht ausfiltern.

Die erfindungsgemäße Aufgabenstellung läßt sich auch mit mehreren Meßspulen beliebiger Weite lösen. In der Praxis wird man die Spulenweite zweckmäßig auf die Polteilung desjenigen Nutzfeldes abstimmen, welches bei einer Störung mit besonders großer Amplitude in Erscheinung tritt. Bei Verwendung von Meßspulen beliebiger Weite müssen eine bestimmte Anzahl von Meßspulen derart am Maschinenumfang verteilt angeordnet und in Reihe geschaltet werden, daß die durch die Läuferunsymmetrien bewirkte resultierende Spannung an der Reihenschaltung der Meßspulen zu einem Maximum, die vom Maschinen-Hauptfeld induzierte Summenspannung zu 0 und die von allen übrigen Luftspaltfeldern induzierte Summenspannung minimal wird. In Figur 3 sind als Beispiel der erfindungsgemäßen Ausgestaltung dieser Gruppenschaltung drei Meßspulen identischer Weite W gegeneinander um den Umfangswinkel $\alpha$ räumlich versetzt. Bei n gleichmäßig versetzt angeordneten Spulen unterscheidet sich die Spannung an der Reihenschaltung aller Spulen von der Spannung jeder Einzelspule um den Faktor

$$S_\mu = \frac{\sin n \frac{\mu \cdot \alpha}{2}}{\sin \frac{\mu \cdot \alpha}{2}}.$$

Diese Art der Meßspulenschaltung wird vorteilhaft bei 2-poligen Maschinen eingesetzt. Für $p = 1$, $n = 2$, $\alpha = \tau$ führen Meßspulen der Weite $W = 1/2 \cdot \tau$ zu dem Ergebnis, daß alle bezeichneten Störfelder in der resultierenden Spannung verschwinden, hingegen die Nutzfelder $\lambda = 2; 6; 10; \ldots$ zu einer maximalen Spannung führen.

4

**Patentansprüche**

1. Anordnung zur meßtechnischen Erfassung und Überwachung von elektrischen Unsymmetrien eines in einem Ständer einer Induktionsmaschine rotierenden Läufers, insbesondere von solchen Unsymmetrien, die durch Stab- oder Ringbrüche in Induktionsmaschinen mit Käfigläufern hervorgerufen werden, mit Hilfe einer aus einer oder mehreren Windungen bestehenden, in der dem Luftspalt zugewandten Bohrungsfläche des Ständerblechpaketes angeordneten Meßspule, dadurch gekennzeichnet, daß die Weite (W) der Meßspule in Umfangsrichtung der Bohrungsfläche so bemessen ist, daß das Maschinenhauptfeld, die Wicklungsoberfelder und Zahnsättigungsfelder in ihr keine Spannung, die durch elektrische Läuferunsymmetrien hervorgerufenen zusätzlichen Luftspaltfelder hingegen eine maximale Spannung induzieren.

2. Anordnung nach Anspruch 1, dadurch gekennzeichnet, daß für eine Maschine mit beliebiger Polpaarzahl p die Weite der Meßspule $W = 2\tau$ ist, wobei $\tau$ die Polteilung des Maschinen-Grundfeldes bezeichnet.

3. Anordnung nach Anspruch 1, dadurch gekennzeichnet, daß bei geradzahliger Polpaarzahl p die Weite der Meßspule $W = p \cdot \tau$ ist, wobei $\tau$ die Polteilung des Maschinen-Grundfeldes bezeichnet.

4. Anordnung zur meßtechnischen Erfassung und Überwachung von elektrischen Unsymmetrien eines in einem Ständer einer Induktionsmaschine rotierenden Läufers, insbesondere von solchen Unsymmetrien, die durch Stab- oder Ringbrüche in Induktionsmaschinen mit Käfigläufern hervorgerufen werden, mit Hilfe von aus einer oder mehreren Windungen bestehenden, in der dem Luftspalt zugewandten Bohrungsfläche des Ständerblechpaketes angeordneten Meßspulen, dadurch gekennzeichnet, daß mehrere Meßspulen beliebiger Weite in Umfangsrichtung der Bohrungsfläche versetzt angeordnet und so in Reihe geschaltet sind, daß die durch die Läuferunsymmetrien induzierte Summenspannung zu einem Maximum, die vom Maschinenhauptfeld induzierte Summenspannung zu null und die von allen übrigen Luftspaltfeldern induzierte Summenspannung null ist bzw. minimal wird.

5. Anordnung nach Anspruch 4, dadurch gekennzeichnet, daß bei 2-poligen Maschinen zwei Meßspulen der Weite $W = 1/2 \cdot \tau$ gegeneinander um den Winkel $\alpha = \pi$ am Umfang räumlich versetzt angeordnet sind, wobei $\tau$ die Polteilung des Maschinen-Grundfeldes bezeichnet.

6. Anordnung nach einem der Ansprüche 1 bis 5, dadurch gekennzeichnet, daß aus der resultierenden Meßspannung solche Anteile herausgefiltert werden, die durch Induzierung von Luftspaltfeldern entstehen, welche nicht von elektrischen Läuferunsymmetrien herrühren und sich von ihnen durch unterschiedliche Frequenzen unterscheiden.

**Claims**

1. Arrangement for the metrological detection and monitoring of electrical asymmetries of a rotor rotating in a stator of an induction motor, particularly of asymmetries caused by rod or ring breaks in induction motors with cage rotors, by means of a measuring coil which consists of one or a plurality of turns and which is arranged in the bore surface, facing the air gap, of the stator laminated pack, characterised in that the width (W) of the measuring coil is dimensioned in the circumferential direction of the bore surface such that the main field of the motor, the upper fields of the turns and the tooth saturation fields do not induce any voltage in the coil, while the additional air gap fields produced by electrical rotor asymmetries produce a maximum voltage.

2. Arrangement according to claim 1, characterised in that the width of the measuring coil is $W = p \cdot \tau$ for a motor with any number of pole pairs p, $\tau$ denoting the pole pitch of the base field of the motor.

3. Arrangement according to claim 1, characterised in that the width of the measuring coil is $W = p \cdot \tau$ in an even number of pole pairs p, $\tau$ denoting the pole pitch of the base field of the motor.

4. Arrangement for the metrological detection and monitoring of electrical asymmetries of a rotor rotating in a stator of an induction motor, particularly of asymmetries caused by rod or ring breaks in induction motors with cage rotors, by means of measuring coils which consist of one or a plurality of turns and which are arranged in the bore surface, facing the air gap, of the stator laminated pack, characterised in that a plurality of measuring coils of any width are arranged in an offset manner in the circumferential direction of the bore surface and connected in series such that the sum voltage indected by the rotor asymmetries reaches a maximum, the sun voltage induced by the main field of the motor becomes zero and the sum voltage induced by all the remaining air gap fields becomes zero or minimal.

5. Arrangement according to claim 4, characterised in that two measuring coils of a width $W = 1/2 \cdot \tau$ are arranged in a spatially offset manner with respect to one another by the angle $\alpha = \pi$ at the circumference in bipolar motors, $\tau$ denoting the pole pitch of the base field of the motor.

6. Arrangement according to one of claims 1 to 5, characterised in that those parts are filtered out of the resulting measuring voltage which result from the induction of air gap fields which do not arise from electrical rotor asymmetries and differ from the latter by different frequencies.

5

**Revendications**

1. Dispositif pour l'acquisition métrologique et le monitorage de déséquilibres électriques d'un induit rotatif dans un stator de machine à induction, en particulier de déséquilibres provoqués par des ruptures de barreaux ou de bagues dans des machines à induction à rotor-cage, au moyen d'une bobine de mesure constituée d'une ou plusieurs spires et logée dans la surface alésée de l'empilage de tôles statorique tournée vers l'entrefer, caractérisé par le fait que la largeur (W) de la bobine de mesure dans la direction périphérique de la surface alésée est dimensionnée de telle manière que le champ principal de machine, les champs supérieurs de bobine et les champs de saturation des dents n'induisent en elle aucune tension au contraire d'une tension maximale de champs d'entrefer additionnels provoqués par des déséquilibres électriques de rotor.

2. Dispositif selon la revendication 1, caractérisé par le fait que, pour une machine à nombre de paires de pôles p donné, la largeur W de la bobine de mesure est égale à $2\tau$, $\tau$ désignant l'écartement polaire du champ fondamental de la machine.

3. Dispositif selon la revendication 1, caractérisé par le fait que, pour un nombre de paires de pôles p pair, la largeur W de la bobine de mesure est égale à $p \cdot \tau$, $\tau$ désignant l'écartement polaire du champ fondamental de la machine.

4. Dispositif pour l'acquisition métrologique et le monitorage de déséquilibres électriques d'un induit rotatif dans un stator de machine à induction, en particulier de déséquilibres provoqués par des ruptures de barreaux ou de bagues dans des machines à induction à rotor-cage, au moyen de bobines de mesure constituées d'une ou plusieurs spires et logées dans la surface alésée de l'empilage de tôles statorique tournée vers l'entrefer, caractérisé par le fait que plusieurs bobines de largeur donnée sont disposées décalées dans la direction périphérique de la surface alésée et connectées en série de manière que la tension totale induite par les déséquilibres de rotor est égale à un maximum, la tension totale induite par le champ principal de machine et la tension totale induite par tous les autres champs d'entrefer sont nulles ou minimales.

5. Dispositif selon la revendication 4, caractérisé par le fait que, pour une machine bipolaire, deux bobines de mesure d'une largeur W égale à $1/2\tau$ sont disposées à la périphérie décalées angulairement l'une par rapport à l'autre d'un angle $\alpha$ égal à $\pi$, $\tau$ désignant l'écartement polaire du champ fondamental de la machine.

6. Dispositif selon l'une des revendications 1 à 5, caractérisé par le fait qu'on sépare par filtrage des parts de la tension de mesure résultante qui se forment par induction de champs d'entrefer qui ne proviennent pas de déséquilibres électriques de rotor et s'en différencient par des fréquences différentes.

Fig.1

Fig.2

Fig.3